# EUROPEAN PATENT SPECIFICATION

(11) **EP 1 262 783 B1**
(45) Date of publication and mention of the grant of the patent: **28.07.2004**
(21) Application number: 02011563.0
(22) Date of filing: 24.05.2002
(51) Int. Cl.: G01R 31/02

(54) **An apparatus, a method for testing an electrical wiring system, a computer program for testing an electrical wiring system**
Vorrichtung und Methode zum Testen eines elektrischen Kabelbaumsystems, Computer-Programm zum Testen eines elektrischen Kabelbaumsystems
Dispositif et procédé pour tester un système de câblage électrique, logiciel pour tester un système de câblage électrique

(30) Priority: 30.05.2001 JP 2001163088
(43) Date of publication of application: 04.12.2002
(73) Proprietor: Sumitomo Wiring Systems, Ltd., Yokkaichi-City, Mie, 510-8503 (JP)
(72) Inventor: Taniguchi, Yoshikazu, Yokkaichi-city, Mie 510-8503 (JP); Mori, Setsurou, Ritto-city, Shiga-pref. 520-3024 (JP)
(74) Representative: Müller-Boré & Partner Patentanwälte

(56) References cited:
- US-A- 4 224 690
- US-A- 4 597 072
- US-A- 4 689 551
- US-A- 5 155 440

## Description

The present invention relates to an apparatus, a method for testing an electric wiring system, a computer program for testing an electric wiring system and a computer-readable storage medium having stored thereon a computer program for testing an electric wiring system.

An electric wiring system represented by a wiring harness generally has a plurality of contacts forming a predetermined electric network. The respective contacts are required to form a proper network determined at the time of designing.

Electrical tests for such an electric wiring system include a dielectric strength test for testing dielectric strengths of the contacts insulated from each other and an electrical connection test for discriminating whether or not connected/disconnected states of the respective contacts form a proper network.

In these electrical tests, specific contacts to be tested are normally selected from a plurality of contacts, connected/disconnected states of all the possible combinations of the selected contacts are detected, and then it is determined whether or not the detected connected/disconnected states are satisfactory.

However, if an electrical test is conducted for all the possible combinations of the respective contacts as mentioned above, a number of tests "N" is: N = m(m-1) where m denotes a total number of contacts in the case of a bilateral test. Thus, if the total number "m" of the contacts is doubled, the number of tests "N" is increased to about a square of the previous number.

Thus, the number of tests excessively increases for a product having a large number of circuits (e.g. 200 circuits) due to an advanced electronization like recent electric wiring systems, and it has disadvantageously taken a considerable time for the electrical tests.

US 4 224 690 discloses a high speed solid state apparatus for learning testing and monitoring an assembly of multiconductor harnesses having a very large number of end points. The apparatus employs plural high speed scanning means which operate independently from each other and simultaneously scan groups of points to identify both continuity and open end circuit conditions. Data representative of the detected interconnections are transferred to memory when all of said plural scanning means have completed the scan for said preselected point.

US 5 155 440 discloses a hand-held apparatus for testing cable harness comprising three sets of voltage references, wherein voltage dividers are utilized to determine reference voltages, each divider comprising a resistor pair. The first set of voltage references is generally associated with odd-numbered wires, wherein the second and the third set of voltage references may be employed for all types of testing, with the second set of voltage references being generally associated with even-numbered wires.

The object of the present invention is to allow to quickly electrically test the electric wiring system having a large number of contacts by maximally reducing the number of electrical tests.

This object is solved according to the invention by an apparatus for testing an electric wiring system according to claim 1, by a method for testing an electric wiring system according to claim 6, by a computer program for testing an electric wiring system according to claim 9 and a computer-readable storage medium having stored thereon a computer program for testing an electric wiring system according to claim 10. Preferred embodiments of the invention are subject of the dependent claims.

According to the invention, there is provided an electrical wiring system testing apparatus for testing connected states of contacts of an electrical wiring system having a plurality of contacts forming an electric network, comprising:
a reference data storage means for storing reference data used as references in testing the connected states,
a reading means for reading the connected states of the electrical wiring system to be compared with the reference data as test data from the contacts, and
a discriminating means for discriminating the connected states of the electrical wiring system by comparing the test data read by the reading means with the reference data stored in the reference data storage means,
wherein, based on the reference data in which the contacts are divided into a plurality of groups characterized in that the groups are divided so as to be insulated from each other, the discriminating means first discriminates (or performs an inter-group discrimination for discriminating) insulated states of the respective contacts among the respective groups and then discriminates (or performs an intra-group discrimination for discriminating) in the respective groups if the insulated states of the respective groups are judged to be satisfactory.

Accordingly, upon conducting an electrical test (e.g. electrical connection test) for the electric wiring system such as a wiring harness, the insulated states of the respective contacts divided beforehand into a plurality of groups insulated from each other are first discriminated among the respective groups (inter-group discrimination) and then discriminated in the respective groups (intra-group discrimination) if the insulated states of the respective groups are judged to be satisfactory. Thus, a total number of the tests can be considerably reduced by conducting the inter-group test as compared to a case where tests are conducted for all possible combinations of all the contacts.

Accordingly, a reduced number of electrical tests are necessary.

According to a preferred embodiment of the invention, the discriminating means preferably at least partly tests the respective contacts in parallel in the respective groups.

In this way, a testing time can be further shortened since the contacts divided into a plurality of groups are or can be simultaneously electrically tested.

Preferably, the number of the contacts included in each group is preferably set using a square root of a total number of the contacts as a target value.

In this way, all the contacts can be electrically tested by a minimum number of tests.

Further preferably, the reading means comprises multiplexing means to enable a multiplexing communication with the plurality of contacts.

Accordingly, the testing apparatus can be made more flexible for different testing applications and/or the number of buses or connections can be advantageously reduced.

Most preferably, a controller sets the contacts to specified (predetermined or predeterminable) electrical states (e.g. pulled-up to a specified voltage level by a pull-up transistor) for allowing the test data to be read by the reading means from the contacts.

According to the invention, there is further provided an electrical wiring system testing method for testing connected states of contacts of an electrical wiring system having a plurality of contacts forming an electric network, wherein, based on reference data in which the contacts are divided into a plurality of groups characterized in that the groups are divided so as to be insulated from each other, in a first discriminating step (inter-group discrimination) insulated states of the respective contacts are first discriminated among the respective groups and in a second (subsequent) discriminating step (intra-group discriminating step) it is then discriminated in the respective groups if the insulated states of the respective groups are judged to be satisfactory.

According to the invention, there is further provided a computer program containing program code means for performing all the steps of the method according to the invention or an embodiment thereof, when said program is run on a computer.

According to the invention, there is still further provided a computer-readable storage means storing a computer program containing program code means for performing all the steps of the method according to the invention or an embodiment thereof, when said program is run on a computer.

Still another aspect of the present invention is directed to an electrical wiring system testing program for testing connected states of contacts of an electrical wiring system having a plurality of contacts forming an electric network or a storage medium for storing such a program, the program causing the electrical wiring system testing apparatus which comprises the reference data storage means for storing the reference data used as the references in testing the connected states; the reading means for reading the connected states of the electrical wiring system to be compared with the reference data as the test data from the contacts, and the discriminating means for discriminating the connected states of the electrical wiring system by comparing the test data read by the reading means with the reference data stored in the reference data storage means to function to first discriminate the insulated states of the respective contacts among the respective groups and then discriminate them in the respective groups if the insulated states of the respective groups are judged to be satisfactory based on the reference data in which the contacts are divided into a plurality of groups insulated from each other.

According to a further aspect of the invention, there is provided a computer program product comprising program code means stored on a computer-readable medium for performing the method according to the invention or an embodiment thereof.

In the present invention, the "electrical test" preferably refers to an electrical connection test, but it is not restricted thereto. For example, the electrical test may be a dielectric strength test for testing a dielectric strength against a high voltage/current although a proximity condition during grouping should be additionally met.

These and other objects, features and advantages of the present invention will become more apparent upon reading of the following detailed description of preferred embodiments and accompanying drawings. It should be understood that even though embodiments are separately described, single features thereof may be combined to additional embodiments.
FIG. 1 is a perspective view diagrammatically showing the external construction of an electrical connection testing apparatus according to one embodiment of the present invention,
FIG. 2 is a circuit construction diagram of the electrical connection testing apparatus of FIG. 1,
FIG. 3 is a diagram showing a state of a perfect time division multiplexing communication by a master unit of this embodiment,
FIGS. 4(A) and 4(B) show a way of the electrical connection test for a wiring harness as an electrical wiring system in the embodiment of FIG. 1, wherein FIG. 4(A) is a wiring diagram showing a network of the wiring harness in a simplified manner, and FIG. 4(B) is a table showing an exemplary case where contacts of the wiring harness are grouped,
FIG. 5 is a flow chart showing a basic operation procedure of this embodiment,
FIG. 6 is a flow chart showing the details of an inter-group test in the operation procedure of FIG. 5,
FIGS. 7(A) to 7(D) are tables showing reference data in the case of conducting the inter-group test for the wiring harness based on conditions described with respect to FIGS. 4(A) and 4(B),
FIG. 8 is a flow chart showing the details of an intra-group test in the operation procedure of FIG. 5, and
FIGS. 9(A) to 9(E) are tables showing reference data in the case of conducting the intra-group test for the wiring harness based on conditions described with respect to FIGS. 4(A) and 4(B).

Hereinafter, a preferable embodiment of the present invention is described in detail with respect to the accompanying drawings.

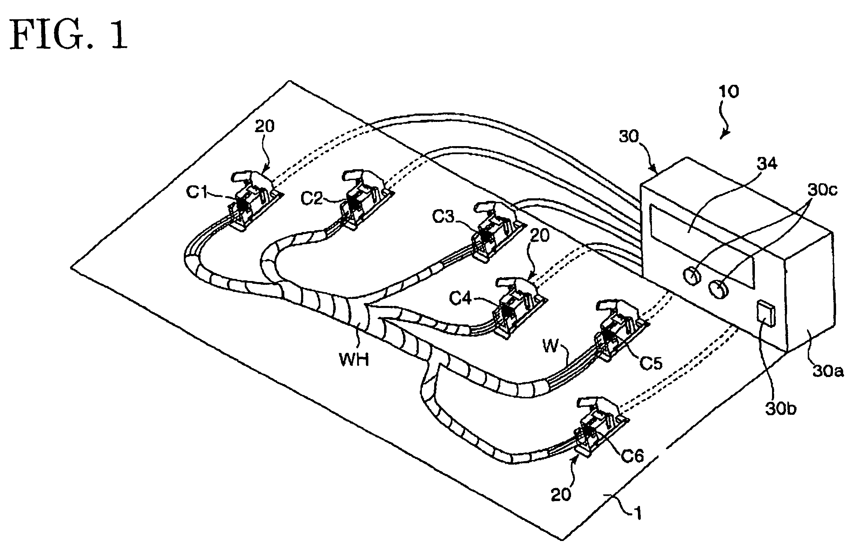

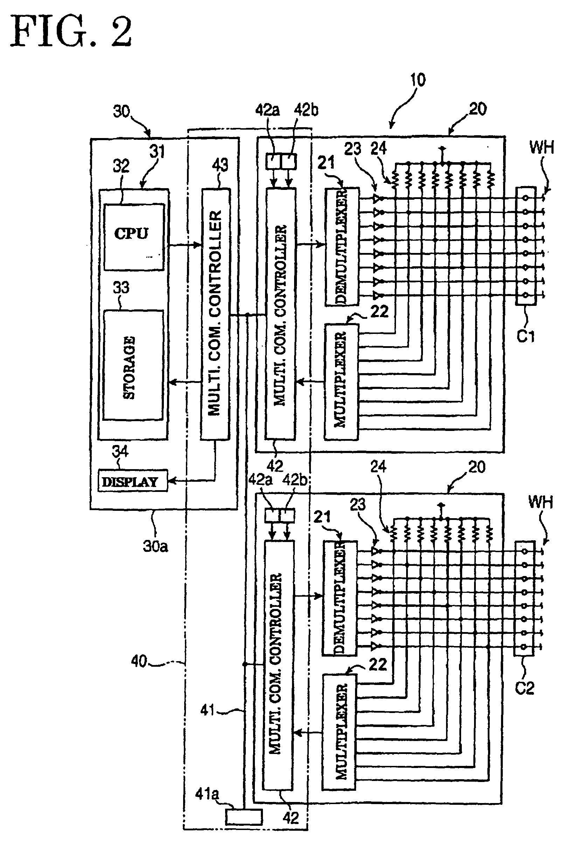

First, with reference to FIGS. 1 and 2, a circuit construction of an electrical connection testing apparatus 10 according to this embodiment is described. FIG. 1 is a perspective view diagrammatically showing the external construction of the electrical connection testing apparatus 10 according to one preferred embodiment of the present invention, and FIG. 2 is a circuit construction diagram of the electrical connection testing apparatus 10 of FIG. 1.

With reference to FIGS. 1 and 2, the electrical connection testing apparatus 10 of this embodiment is designed as a testing apparatus for testing an electrical connection of a wiring harness WH as an electric wiring system.

In the shown example, the electrical connection testing apparatus 10 is installed on a testing board 1 and includes connector units 20 provided for a plurality connectors C1 to C6 connected with the wiring harness WH to be tested, and a master unit 30 which is so connected with the respective connector units 20 as to enable a multiplexing communication (i.e. the transmission of two or more signals and/or data over a single channel).

With reference to FIG. 2, each connector unit 20 is provided with a demultiplexer 21 having outputs corresponding to the number of contacts of a connector C1 (C2 to C6) to be connected, a multiplexer 22 having the output of the demultiplexer 21 as a data input, a plurality of inverters 23 and a plurality of pullup resistors 24 provided for the respective outputs of the demultiplexer 21, and unillustrated probe pins for connecting the outputs of the demultiplexer 21 and the connector C1 (or one of C2 to C6). In accordance with an output signal from the master unit 30 to be described later, signals are outputted from the demultiplexer 21 and pullup currents are caused to flow via the pullup resistors 24, whereby terminals T1 to T16 of the connector C1 (C2 to C6) connected with the connector unit 20 can be selectively specified to bring them to an electrically active state and electrically connected states of the respective terminals T1 to T16 can be detected by the multiplexer 22.

On the other hand, the master unit 30 is provided with a controller 31 for controlling the respective connector units 20. The controller 31 includes a CPU (central processing unit) 32, a storage 33 connected with this CPU 32, and a display 34 for displaying contents of processing.

In the storage 33 are stored an electrical connection testing program for causing the CPU 33 to function as an electrical connection testing device and an address setting program for giving node addresses of a multiplexing communication controller 43 to be described later. The storage 33 is also used as a work area or virtual working memory of the CPU 32 and the like. Further, the storage 33 is so set as to store an electrical connection information of contacts of a network to be formed in the wiring harness WH being tested as reference data and to store a read information on the wiring harness WH being tested which is obtained via a multiplexing communication system 40 to be described later as a test data.

The display 34 displays contents of controls of the controller 31 by being connected with the controller 31 via the multiplexing communication controller 43 of the multiplexing communication system 40 to be described later. In the shown example, the display 34 is realized by a liquid crystal panel mounted on a casing 30a (see FIG. 1).

The connector units 20 and the master unit 30 are connected by the multiplexing communication system 40 such that a multiplexing communication can be conducted therebetween.

The multiplexing communication system 40 includes a multiplexing communication bus 41 forming a LAN (local area network) bus, multiplexing communication controllers 42 provided in the respective connector units 20, and the multiplexing communication controller 43 provided in the master unit 30. Identified by 41a in FIG. 2 is a network terminator of the bus 41.

The multiplexing communication controller 42 provided in each connector unit 20 includes a self node address setting switch 42a and a transmission-end node address setting switch 42b, and can set or define a self node address and a transmission-end node address (address set as a self node address in the multiplexing communication controller 43 of the master unit 30 in this embodiment) which are different from each other by means of the switches 42a, 42b.

On the other hand, the CPU 32 sets or defines the self node address and the transmission-end node address in the multiplexing communication controller 43 provided in the master unit 30.

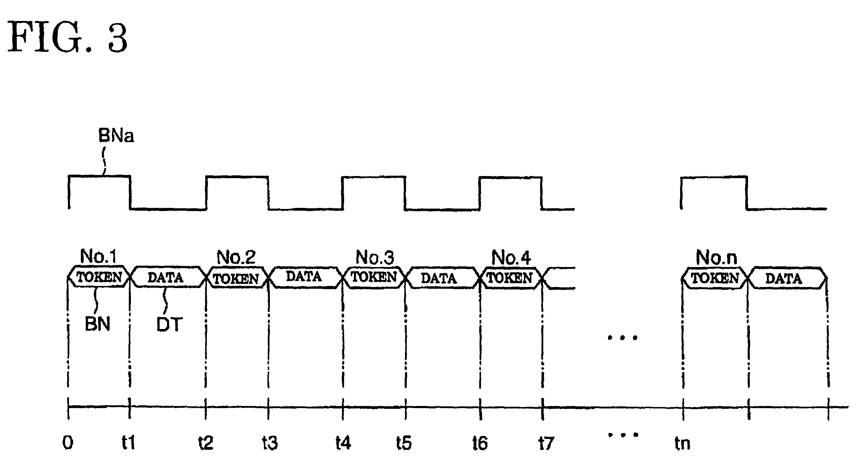

FIG. 3 is a diagram showing a state of a perfect time division multiplexing communication by the master unit 30 of this embodiment.

In FIG. 3, a horizontal axis represents time, BNa and BN denote an issuing cycle of token signals by the master unit 30 and a timing bit set issued as the token signal, respectively. In the shown example, an output is preferably made by a frequency-modulation method adopting a broadband system.

In this embodiment, the master unit 30 repeatedly issues the token signal in a cycle of a period between 0 and t2. The master unit 30 issues the token signals as a timing marker during the front halves of the cycles 0 to t1, t2 to t3, t4 to t5, t6 to t7, etc., whereas the units 20, 30 having the self node address coinciding with the node address of the issued token output a data DT to a bus B (or 41) during the rear halves of the cycles t1 to t2, t3 to t4, t5 to t6, etc. In this way, the master unit 30 conducts a perfect time division multiplexing communication in which tokens are given to all the units including itself by successively repeating the issuance of the timing bit set BN by the number of the units. The respective units 20, 30 can output data packets between the respective timing bit sets and all the units 20, 30 can commonly use the outputted data packets in the bus 41. Accordingly, the respective connector units 20 can share the bit set information and simultaneously make the terminals corresponding to themselves active by outputting an electrical connection test information of all the terminal fittings T1 to T16 as one bit set information from the master unit 30.

Pieces of the read information can be outputted in parallel from the respective connector units 20 by conducting the perfect time division multiplexing communication. Thus, a response time elapsing until the read information from each connector unit is received after the output of one instruction signal from the master unit 30 can be remarkably shortened.

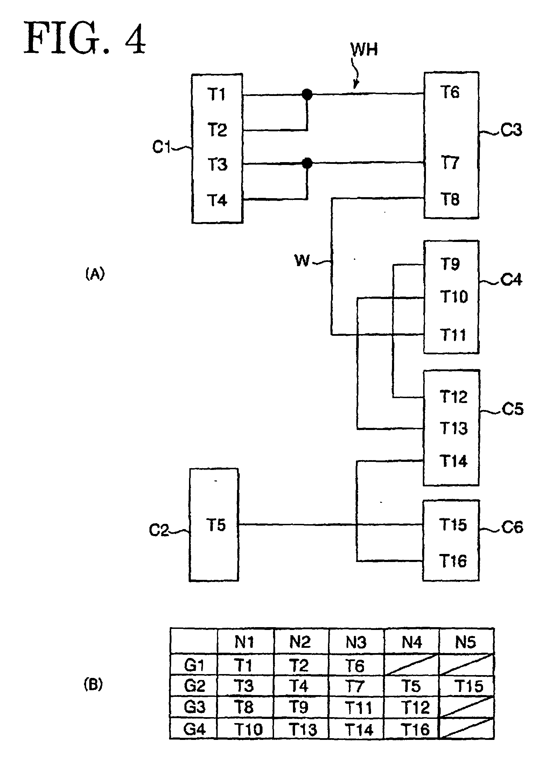

Next, a circuit construction of the wiring harness WH to be tested is described with reference to FIGS. 4(A) and 4(B). FIGS. 4(A) and 4(B) show a way of an electrical test for the wiring harness WH as an electric wiring system in the embodiment shown in FIG. 1, wherein FIG. 4(A) is a wiring diagram showing a network of the wiring harness WH in a simplified manner and FIG. 4(B) shows an exemplary table in which contacts corresponding to the wiring harness WH of FIG. 4(A) are grouped. Although the shown example is simplified in order to facilitate the description, an electrical connection test for the wiring harness having, for example, 960 points of contact (terminals) is supposed in this embodiment.

First, with reference to FIG. 4(A), the wiring harness WH is comprised of a plurality of connectors C1 to C6, the terminals T1 to T16 accommodated in the respective connectors C1 to C6, and wires W for connecting specific terminals.

In the shown example, the respective terminals T1 to T16 are connected in the following manner:
- T1, T2 and T6 are connected with each other, but insulated from the other terminals.
- T3, T4 and T7 are connected with each other, but insulated from the other terminals.
- T5 and T15 are connected with each other, but insulated from the other terminals.
- T8 and T11 are connected with each other, but insulated from the other terminals.
- T9 and T12 are connected with each other, but insulated from the other terminals.
- T10 and T13 are connected with each other, but insulated from the other terminals.
- T14 and T16 are connected with each other, but insulated from the other terminals.

In the case of testing the electrical connection of such a wiring harness WH, it is preferable to divide the respective terminals T1 to T16 into four groups G1 to G4 as shown in FIG. 4(B).

The terminals T1 to T16 are grouped such that the respective groups G1 to G4 are insulated from each other. For example, the terminals T1, T2 and T6 forming the group G1 are not electrically connected with the terminals of any other group G2 to G4. This also applies to the terminals T3, T4, T7, T5 and T15 forming the group G2, the terminals T8, T9, T11 and T12 forming the group G3 and the terminals T10, T13, T14 and T16 forming the group G4.

The numbers of the terminals forming the respective groups G1 to G4 are set using a square root of the total number of the terminals as a target value. In the shown example, the total number of the terminals T1 to T16 is 16. Thus, the number of the terminals in each group is adjusted to 4 or any integer closest to 4 or by a corresponding rounding to the closest integer value (e.g. if the calculated number of terminals is 4.1 or 4.2 the number of terminals is set to be 4 while if the calculated amount is 4.5 it is set to 5). When N, m and n denote the total number of the terminals, the number of the groups G1 to G4, and the uniform number of the terminals in each group, respectively, the value of n which minimizes a total number of tests to be conducted is obtained as follows on the conditions that tests are first conducted for all the possible combinations of m groups and then for all the possible combinations of the terminals in the respective groups.$\text{N = m × n}$ An equation for a total number of tests X is:$\text{X = m(m-1) + n(n-1)}$ By putting equation (1) into equation (2), following equation (3) is obtained.$\text{X = N/n(N/n - 1) + n(n - 1)}$ Then, based on a condition to minimize the total number of tests:$\text{dX/dn = 0}$$\frac{\text{dX}}{\text{dn}} \text{=} {\text{N}}^{\text{2}} \text{(} \frac{\text{-2} \text{n}}{{\text{n}}^{\text{4}}} \text{) + 2} \text{n} \text{- (} \frac{\text{-} \text{N}}{{\text{n}}^{\text{2}}} \text{) - 1= 0}$ If following equation (6) is solved for n,${\text{2n}}^{\text{4}} {\text{- n}}^{\text{3}} {\text{+ Nn -2N}}^{\text{2}} \text{= 0}$${\text{n = N}}^{\text{(1/2)}}$ because n>0.

Although the number of tests is reduced in intra-group electrical connection tests since a plurality of terminals are simultaneously tested, the number of the terminals in each group is preferably set at a value satisfying equation (7) even in such a case.

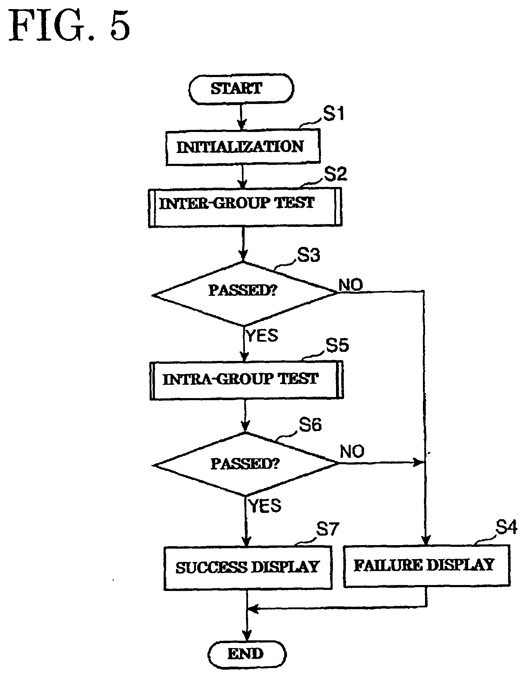

Next, how the embodiment described above acts is described with reference to a flow chart of FIG. 5.

FIG. 5 is a flow chart showing a basic operation procedure of this embodiment.

With reference to FIG. 5, initialization is carried out (Step S1) after the testing apparatus is turned on e.g. by actuating a power-switch 30b. Mainly in this initialization, the CPU 32 of the controller 31 is initialized and the product number of the wiring harness WH to be tested is set.

After the initialization in Step S1, the controller 31 conducts an inter-group test for testing an insulated state among the respective groups G1 to G4 (Step S2) and discriminates whether or not the respective groups G1 to G4 have passed the tests (Step S3).

If any failure in passing the above tests is discriminated at this stage, the controller 31 makes a failure display on the display 34 and completes this processing (Step S4).

On the other hand, if all the groups G1 to G4 have passed the tests, the controller 31 proceeds to the next Step.

Upon completion of the inter-group test, the controller 31 conducts intra-group tests for testing the electrically connected states of all the possible combinations of the respective terminals T1 to T16 in the groups G1 to G4 (Step S5) and discriminates whether or not the terminals T1 to T16 have passed the tests (Step S6). If any failure is discriminated in the intra-group test, the controller 31 makes a failure display on the display 34 in Step S4. On the other hand, if the wiring harness WH is discriminated to be satisfactory, the controller 31 completes this processing after making a success display on the display 34 (Step S7).

In the respective tests, the data packets are transmitted and received between a plurality of connector units 20 connected with the wiring harness WH being tested and the master unit 30 connected with the respective connector units 20 by the perfect time division multiplexing communication method by means of the multiplexing communication system 40. In this way, each connector unit 20 outputs corresponding output signals from the demultiplexer 21 and causes the pullup currents to flow via the pullup resistors 24, whereby the respective contacts of the connectors C1 (C2 to C6) connected with the connector unit 20 are selectively specified and brought to specified (predetermined or predeterminable) electrically active states (such as a specified voltage), and the electrically connected states of the respective contacts can be detected by the multiplexer 22.

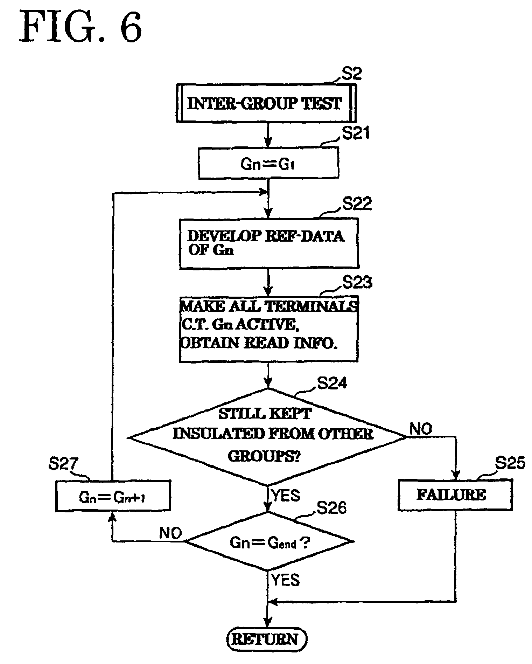

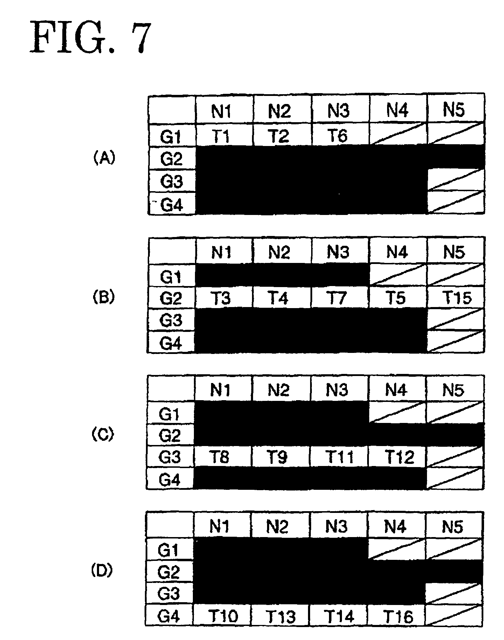

Next, the inter-group test is described in more detail with reference to FIGS. 6 and 7. FIG. 6 is a flow chart showing the details of the inter-group test of step S2 in the operation procedure of FIG. 5, and FIGS. 7(A) to 7(D) are tables showing reference data in the case of conducting the inter-group test for the wiring harness WH based on the conditions described with reference to FIGS. 4(A) and 4(B).

With reference to FIGS. 6 and 7, the group to be tested is first initialized in the inter-group test (Step S21) and the reference data (data shown in FIGS. 7(A) to 7(D)) of the group Gn to be first tested is developed or established (Step S22). FIGS. 7(A) to 7(D) show relationships of the respective groups G1 to G4 in their active state (state where the terminals have a voltage different from the other terminals not being tested) with the other groups in table format. For example, in the case of testing the group G1, all the terminals of the groups G2 to G4 are OFF (painted out in black in FIG. 7).

As shown in FIG. 6, after Step S22, the controller 31 brings all the terminals corresponding to the group Gn being tested to the active state, and reads the electrically connected states of the terminals of the other groups to obtain the read information as a test data (Step S23). The obtained test data and the developed or established reference data are compared to check whether or not the respective terminals of the group Gn being tested are electrically shorted with the other terminals (step S24). In this way, the terminals which should be electrically insulated are tested at once.

If the group Gn being tested in the inter-group test is detected to be shorted with the other group(s) in Step S2, a failure judgment is made (Step S25) and this subroutine returns to the main routine. Thus, the aforementioned failure display (Step S4) is made in this case and the main routine is terminated.

On the other hand, if the group Gn being tested is discriminated to be satisfactory, it is determined whether or not there still remains any untested group (Step S26). If there still remains the untested group, the group Gn to be tested is renewed or changed or increased to Gₙ₊₁ (Step S27) and Step S22 follows. If there remains no untested group, this subroutine returns to the main routine.

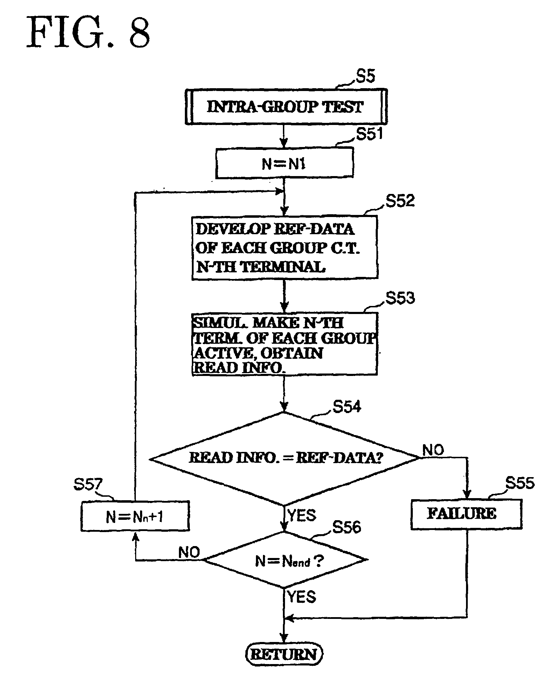

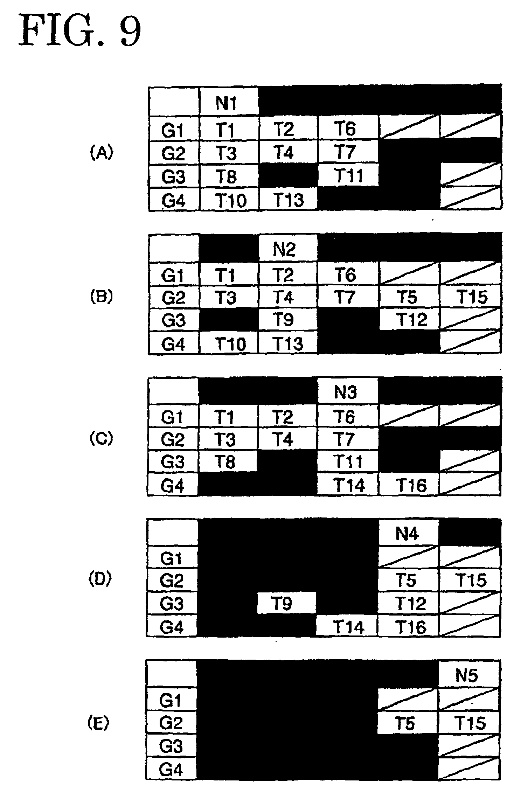

Next, the intra-group test (step S5) is described in detail with reference to FIGS. 8 and 9. FIG. 8 is a flow chart showing the details of the intra-group test in the operation procedure of FIG. 5, and FIGS. 9(A) to 9(E) are tables showing reference data in the case of conducting the intra-group test for the wiring harness based on the conditions described with reference to FIGS. 4(A) and 4(B).

In the intra-group test, the electrically connected states of the respective terminals T1 to T16 in the groups G1 to G4 with those in the corresponding groups G1 to G4 are tested.

With reference to FIGS. 8 and 9, in the intra-group test, the terminal to be tested is first initialized (Step S51) and then the reference data (data shown in FIGS. 9(A) to 9(E)) of the terminal to be first tested is developed or established (Step S52). FIGS. 9(A) to 9(E) show relationships of the terminals being tested in their active state with the other terminals in table format. For example, in the case of testing the terminal T1, the terminals T2, T6 which should be connected with the terminal T1 are electrically connected (see FIG. 9(A)).

In this embodiment, the terminals of the respective groups G1 to G4 are simultaneously tested upon successively (in the order to N1 to N5) testing all the possible combinations of the respective terminals T1 to T16.

For example, in the first electrical connection test, the N1-th terminals T3, T8, T10 of the other groups G2 to G4 are brought to the active state simultaneously with the terminal T1 of the group G1 and all the terminals T4, T7, T11, T13 which should be electrically connected with these terminals T3, T8, T10 are registered as those to be electrically connected as shown in FIG. 9(A). There is no problem in conducting the electrical connection test with such a setting since the respective groups G1 to G4 are already detected to be insulated from each other in the inter-group test.

In this way, in the case of conducting the intra-group test of one group, the intra-group tests of the other groups are or can be at least partly simultaneously conducted.

As shown in FIG. 8, after Step S52, the controller 31 brings all the terminals being tested (T1, T3, T8, T10 in the case of FIG. 9(A)) to the active state, and reads the electrically conducted states of the other terminals to obtain the read information as a test data (Step S53). The obtained test data and the developed reference data are compared to check whether or not the respective terminals T1, T3, T8, T10 being tested are electrically shorted with the terminals other than the proper ones (painted out in black in FIG. 9) shown in FIG 9. In this way, a plurality of terminals are simultaneously tested in parallel in the respective groups.

If the terminal being tested in the intra-group test of Step S54 is detected to be shorted with the terminal from which it should be insulated, a failure judgment is made (Step S55) and this subroutine returns to the main routine. Thus, the aforementioned failure display (Step S4) is made in this case and the main routine is terminated.

On the other hand, if the terminals being tested are discriminated to be satisfactory, it is determined whether or not there still remains any untested terminal (Step S56). If there still remains the untested terminal, the terminal to be tested is renewed or the terminal to be tested is set to Nₙ₊₁ (Step S57) and Step S52 follows. If there remains no untested terminal, this subroutine returns to the main routine.

As described above, according to this embodiment, upon conducting an electrical test (e.g. electrical connection test) for an electric wiring system such as the wiring harness WH, the insulated states of the terminals T1 to T16 (contacts) divided beforehand into a plurality of groups G1 to G4 which are insulated from each other are first discriminated among the respective groups G1 to G4 and then in the respective groups G1 to G4 if the respective groups are judged to be insulated from each other. Thus, as compared to a case where tests are conducted for all the possible combinations of the terminals T1 to T16, the total number X of the tests can be considerably reduced by conducting the inter-group test.

Accordingly, a reduced number of electrical tests are necessary.

Since the respective terminals T1 to T16 can be preferably tested in parallel in the respective groups G1 to G4 in this embodiment, a testing time can be further shortened.

Further, since the groups G1 to G4 of the reference data are set using the square root of the total number of the terminals T1 to T16 as a target value, all the terminals T1 to T16 can be electrically tested by a minimum number of the tests as is clear from the aforementioned equations (1) to (7).

The foregoing embodiment is only a specific example of the preferred embodiment of the present invention and does not restrict the present invention as defined by the claims.

For example, the electrical test may be an inter-wire voltage resistance test or an insulation resistance test as disclosed, e.g. in Japanese Unexamined Patent Publication No. 6-290843.

The master unit 30 can be formed by various computers. In such a case, the electrical connection test program can be preferably implemented by being stored in various computer-readable mediums (e.g. CD-ROM).

Needless to say, various design changes can be made without departing from the scope of the present invention as claimed.

As described above, according to the present invention, the total number of the tests can be considerably reduced by conducting the inter-group test as compared to the case where tests are conducted for all the possible combinations of all the contacts. Thus, there are remarkable effects that the number of the electrical tests can be maximally reduced and, therefore, the electrical wiring system having a large number of contacts can be quickly electrically tested.

Accordingly, in order to quickly electrically test an electrical wiring system having a large number of contacts by maximally reducing the number of electrical tests, a plurality of contacts forming a network of an electrical wiring system is first divided into a plurality of groups, wherein the respective groups are insulated from each other. Then, the insulated states of these groups are discriminated (inter-group discrimination), and the insulated states of the respective contacts in the respective groups are subsequently discriminated (intra-group discrimination) if the insulated states of the respective groups are judged to be satisfactory.

### LIST OF REFERENCE NUMERALS

- 10: electrical connection testing apparatus
- 20: connector unit
- 30: master unit
- 31: controller
- 32: CPU
- 33: storage
- 34: display
- 40: multiplexing communication system
- T1 to T16: terminal (example of contact)
- W: wire
- WH: wiring harness
- X: a total test number

## Claims

1. An electrical wiring system testing apparatus (10) for testing connected states of contacts (T1-T16) of an electrical wiring system (WH) having a plurality of contacts (T1-T16) forming an electric network, comprising:
a reference data storage means (33) for storing reference data (FIG. 7A-7D) used as references in testing the connected states,
a reading means (20; 30) for reading the connected states of the electrical wiring system (WH) to be compared with the reference data (FIG. 7A-7D) as test data from the contacts (T1-T16), and
a discriminating means (32) for discriminating the connected states of the electrical wiring system (WH) by comparing the test data read by the reading means (20; 30) with the reference data (FIG. 7A-7D) stored in the reference data storage means (33),
**characterized in that**, based on the reference data (FIG. 7A-7D) in which the contacts (T1-T16) are divided into a plurality of groups (G1-G4), so as to be insulated from each other, the discriminating means (32) is configured to first discriminate insulated states of the respective contacts (T1-T16) among the respective groups (G1-G4) and then to discriminate in the respective groups (G1-G4) if the insulated states of the respective groups (G1-G4) are judged to be satisfactory.

2. An electrical wiring system testing apparatus according to claim 1, wherein the discriminating means (32) is configured to at least partly test the respective contacts (T1-T16) in parallel in the respective groups (G1-G4).

3. An electrical wiring system testing apparatus according to one or more of the preceding claims, wherein the number (n) of the contacts (T1-T16) included in each group (G1-G4) is set using a square root of a total number (N) of the contacts (T1-T16) as a target value.

4. An electrical wiring system testing apparatus according to one or more of the preceding claims, wherein the reading means (20; 30) comprises multiplexing means to enable a multiplexing communication with the plurality of contacts (T1-T16).

5. An electrical wiring system testing apparatus according to one or more of the preceding claims, wherein a controller (31) is configured to set the contacts (T1-T16) to specified electrical states for allowing the test data to be read by the reading means (20; 30) from the contacts (T1-T16).

6. An electrical wiring system testing method for testing connected states of contacts (T1-T16) of an electrical wiring system (WH) having a plurality of contacts (T1-T16) forming an electric network, wherein, based on reference data (FIG. 7A-7D) in which the contacts (T1-T16) are divided into a plurality of groups (G1-G4), **characterized in that** the groups (G1-G4) are divided so as to be insulated from each other, in a first discriminating step (S2; S3) insulated states of the respective contacts (T1-T16) are first discriminated among the respective groups (G1-G4) and in a second discriminating step (S5; S6) it is then discriminated in the respective groups (G1-G4) if the insulated states of the respective groups (G1-G4) are judged to be satisfactory.

7. An electrical wiring system testing method according to claim 6, wherein in the second discriminating step (S5; S6) the respective contacts (T1-T16) are at least partly tested in parallel in the respective groups (G1-G4).

8. An electrical wiring system testing method according to claim 6 or 7, wherein the number (n) of the contacts (T1-T16) included in each group (G1-G4) is set using a square root of a total number (N) of the contacts (T1-T16) as a target value.

9. A computer program containing program code means for performing all the steps of claim 6 or 7, when said program is run on a computer.

10. A computer-readable storage means storing a computer program containing program code means for performing all the steps of claim 6 or 7, when said program is run on a computer.

## Patentansprüche

1. Vorrichtung (10) zum Testen eines elektrischen Verdrahtungs- bzw. Kabelbaumsystems zum Testen von verbundenen Zuständen von Kontakten (T1 - T16) eines elektrischen Verdrahtungs- bzw. Kabelbaumsystems (WH), welches eine Vielzahl von Kontakten (T1 - T16) aufweist, welche ein elektrisches Netzwerk ausbilden, umfassend:
Referenzdaten-Speichermittel (33) zum Speichern von Bezugs- bzw. Referenzdaten (Fig. 7A - 7D), welche als Referenzen beim Testen der verbundenen Zustände verwendet werden,
Lesemittel (20; 30) zum Lesen der verbundenen Zustände des elektrischen Kabelbaumsystems (WH), um mit den Referenzdaten (Fig. 7A - 7D) als Testdaten von den Kontakten (T1 - T16) verglichen zu werden, und
Unterscheidungsmittel (32) zum Unterscheiden der verbundenen Zustände des elektrischen Kabelbaumsystems (WH) durch ein Vergleichen der Testdaten, welche durch die Lesemittel (20; 30) eingelesen werden, mit den Referenzdaten (Fig. 7A - 7D), welche in den Referenzdaten-Speichermitteln (33) gespeichert sind,
**dadurch gekennzeichnet, daß** basierend auf den Referenzdaten (Fig. 7A - 7D), in welchen die Kontakte (T1 - T16) in eine Vielzahl von Gruppen (G1 - G4) so unterteilt sind, um voneinander isoliert zu sein, die Unterscheidungsmittel (32) konfiguriert sind, um zuerst isolierte Zustände der entsprechenden Kontakte (T1 - T16) unter den entsprechenden Gruppen (G1 - G4) zu unterscheiden und dann in den entsprechenden Gruppen (G1 - G4) zu unterscheiden, wenn die isolierten Zustände der entsprechenden Gruppen (G1 - G4) als zufriedenstellend beurteilt sind.

2. Vorrichtung zum Testen eines elektrischen Kabelbaumsystems nach Anspruch 1, wobei die Unterscheidungsmittel (32) konfiguriert sind, um wenigstens teilweise die entsprechenden Kontakte (T1 - T16) parallel in den entsprechenden Gruppen (G1 - G4) zu testen.

3. Vorrichtung zum Testen eines elektrischen Kabelbaumsystems nach einem oder mehreren der vorangehenden Ansprüche, wobei die Anzahl (n) der Kontakte (T1 - T16), welche in jeder Gruppe (G1 - G4) enthalten sind, unter Verwendung einer Quadratwurzel einer Gesamtanzahl (N) der Kontakte (T1 - T16) als ein Zielwert eingestellt bzw. festgelegt ist.

4. Vorrichtung zum Testen eines elektrischen Kabelbaumsystems nach einem oder mehreren der vorangehenden Ansprüche, wobei die Lesemittel (20, 30) Multiplexmittel umfassen, welche eine multiplexierende Kommunikation bzw. Verbindung mit der Vielzahl von Kontakten (T1 - T16) ermöglichen.

5. Vorrichtung zum Testen eines elektrischen Kabelbaumsystems nach einem oder mehreren der vorangehenden Ansprüche, wobei eine Regel- bzw. Steuereinrichtung bzw. ein Controller (31) konfiguriert ist, um die Kontakte (T1 - T16) auf bestimmte elektrische Zustände einzustellen, um zu erlauben, daß die Testdaten durch die Lesemittel (20; 30) von den Kontakten (T1 - T16) eingelesen werden.

6. Verfahren zum Testen eines elektrischen Verdrahtungs- bzw. Kabelbaumsystems zum Testen von verbundenen bzw. angeschlossenen Zuständen von Kontakten (T1 - T16) eines elektrischen Verdrahtungs- bzw. Kabelraumsystems (WH), welches eine Vielzahl von Kontakten (T1 - T16) aufweist, welche ein elektrisches Netzwerk ausbilden, wobei basierend auf Referenz- bzw. Bezugsdaten (Fig. 7A - 7D), in welchen die Kontakte (T1 - T16) in eine Vielzahl von Gruppen (G1 - G4) unterteilt werden, **dadurch gekennzeichnet, daß** die Gruppen (G1 - G4) so unterteilt werden, um voneinander isoliert zu sein, in einem ersten diskriminierenden bzw. unterscheidenden bzw. Unterscheidungsschritt (S2; S3) isolierte Zustände der entsprechenden Kontakte (T1 - T16) zuerst unter den entsprechenden Gruppen (G1 - G4) unterschieden bzw. diskriminiert werden und in einem zweiten diskriminierenden bzw. unterscheidenden Schritt (S5; S6) dann in den entsprechenden Gruppen (G1 - G4) unterschieden wird, ob die isolierten Zustände der entsprechenden Gruppen (G1 - G4) als zufriedenstellend beurteilt werden.

7. Verfahren zum Testen eines elektrischen Kabelbaumsystems nach Anspruch 6, wobei in dem zweiten unterscheidenden Schritt (S5; S6) die entsprechenden Kontakte (T1 - T16) wenigstens teilweise parallel in den entsprechenden Gruppen (G1 - G4) getestet werden.

8. Verfahren zum Testen eines elektrischen Kabelbaumsystems nach Anspruch 6 oder 7, worin die Anzahl (n) der Kontakte (T1 - T16), welche in jeder Gruppe (G1 - G4) enthalten sind, unter Verwendung einer Quadratwurzel einer Gesamtanzahl (N) der Kontakte (T1 - T16) als ein Zielwert eingestellt bzw. festgelegt wird.

9. Computerprogramm, enthaltend Programmcodemittel zum Durchführen sämtlicher Schritte von Anspruch 6 oder 7, wenn das Programm an einem Computer abläuft.

10. Computerlesbare Speichermittel, welche ein Computerprogramm speichern, welches Programmcodemittel zum Durchführen sämtlicher Schritte von Anspruch 6 oder 7 beinhaltet, wenn das Programm auf einem Computer abläuft.

## Revendications

1. Appareil de test de système de câblage électrique (10) pour tester les états connectés des contacts (T1 à T16) d'un système de câblage électrique (WH) possédant une pluralité de contacts (T1 à T16) formant un réseau électrique, comprenant :
un moyen de stockage des données de référence (33) pour stocker des données de référence (figures 7A à 7D) utilisées comme références lors du test des états connectés,
un moyen de lecture (20 ; 30) pour lire les états connectés du système de câblage électrique (WH) à comparer avec les données de référence (figures 7A à 7D) comme des données de test provenant des contacts (T1 à T16), et
un moyen de séparation (32) pour séparer les états connectés du système de câblage électrique (WH) en comparant les données de test lues par le moyen de lecture (20 ; 30) aux données de référence (figures 7A à 7D) stockées dans le moyen de stockage des données de référence (33),
**caractérisé en ce que** , en fonction des données de référence (figures 7A à 7D) dans lesquelles les contacts (T1 à T16) sont divisés en une pluralité de groupes (G1 à G4)
de façon à être isolés les uns des autres, le moyen de séparation (32) étant configuré pour séparer dans un premier temps les états isolés des contacts respectifs (T1 à T16) parmi les groupes respectifs (G1 à G4) puis pour effectuer une séparation au sein des groupes respectifs (G1 à G4) si les états isolés des groupes respectifs (G1 à G4) sont jugés satisfaisants.

2. Appareil de test de système de câblage électrique selon la revendication 1, dans lequel le moyen de séparation (32) est configuré pour tester au moins en partie les contacts respectifs (T1 à T16) en parallèle dans les groupes respectifs (G1 à G4).

3. Appareil de test de système de câblage électrique selon l'une ou plusieurs des revendications précédentes, dans lequel le nombre (n) de contacts (T1 à T16) compris dans chaque groupe (G1 à G4) est défini en utilisant la racine carrée d'un nombre total (N) de contacts (T1 à T16) comme une valeur cible.

4. Appareil de test de système de câblage électrique selon l'une ou plusieurs des revendications précédentes, dans lequel le moyen de lecture (20 ; 30) comprend un moyen de multiplexage pour permettre une communication de multiplexage avec la pluralité de contacts (T1 à T16).

5. Appareil de test de système de câblage électrique selon l'une ou plusieurs des revendications précédentes, dans lequel un contrôleur (31) est configuré pour définir les contacts (T1 à T16) afin de spécifier les états électriques pour permettre la lecture des données de test par le moyen de lecture (20 ; 30) à partir des contacts (T1 à T16).

6. Procédé de test de système de câblage électrique pour tester les états connectés des contacts (T1 à T16) d'un système de câblage électrique (WH) possédant une pluralité de contacts (T1 à T16) formant un réseau électrique, dans lequel, en fonction de données de référence (figures 7A à 7D) dans lesquelles les contacts (T1 à T16) sont divisés en une pluralité de groupes (G1 à G4), **caractérisé en ce que** les groupes (G1 à G4) sont divisés de façon à être isolés les uns des autres, dans une première étape de séparation (S2 ; S3) des états isolés des contacts respectifs (T1 à T16) sont tout d'abord séparés parmi les groupes respectifs (G1 à G4) et dans une seconde étape de séparation (S5 ; S6) une séparation est effectuée dans les groupes respectifs (G1 à G4) si les états isolés des groupes respectifs (G1 à G4) sont jugés satisfaisants.

7. Procédé de test de système de câblage électrique selon la revendication 6, dans lequel lors de la seconde étape de séparation (S5 ; S6) les contacts respectifs (T1 à T16) sont au moins en partie testés en parallèle dans les groupes respectifs (G1 à G4).

8. Procédé de test de système de câblage électrique selon la revendication 6 ou 7, dans lequel le nombre (n) de contacts (T1 à T16) compris dans chaque groupe (G1 à G4) est défini en utilisant la racine carrée d'un nombre total (N) de contacts (T1 à T16) en tant que valeur cible.

9. Programme informatique comprenant un moyen de code de programme pour effectuer toutes les étapes de la revendication 6 ou 7, lorsque ledit programme est lancé sur un ordinateur.

10. Moyen de stockage lisible pas un ordinateur stockant un programme informatique comprenant un moyen de code de programme pour exécuter toutes les étapes de la revendication 6 ou 7, lorsque ledit programme est lancé sur un ordinateur.
